# FASCICULE DE BREVET EUROPEEN

(11) **EP 4 186 103 B1**
(45) Date de publication et mention de la délivrance du brevet: **01.05.2024**
(21) Numéro de dépôt: 21769763.0
(22) Date de dépôt: 08.07.2021
(51) Int. Cl.: H01L 31/0203, H01L 23/552

(54) **ENSEMBLE DE BLINDAGE ÉLECTROMAGNÉTIQUE TRANSPARENT OPTIQUEMENT**
OPTISCH TRANSPARENTE ELEKTROMAGNETISCHE ABSCHIRMANORDNUNG
OPTICALLY TRANSPARENT ELECTROMAGNETIC SHIELDING ASSEMBLY

(30) Priorité: 22.07.2020 FR 2007712
(43) Date de publication de la demande: 31.05.2023
(73) Titulaire: Safran Electronics & Defense, 75015 Paris (FR); Université de Rennes 1, 35000 Rennes (FR); Centre National de la Recherche Scientifique (CNRS), 75016 Paris (FR)
(72) Inventeur: TRICAS, Quentin, 75015 PARIS (FR); FOUTREL, Patrice, 75015 PARIS (FR); BESNIER, Philippe, 75016 PARIS (FR); CASTEL, Xavier, 35000 RENNES (FR); LE PAVEN, Claire, 35000 RENNES (FR)
(74) Mandataire: Plasseraud IP
(86) Numéro de dépôt international: PCT/FR2021/051264
(87) Numéro de publication internationale: WO 2022/018346

(56) Documents cités:
- US-A1- 2011 115 686
- US-A1- 2014 146 511
- US-A1- 2017 237 157
- US-A1- 2020 173 859

## Description

### Domaine technique

La présente description concerne un ensemble de blindage électromagnétique qui est transparent optiquement.

### Technique antérieure

De nombreuses applications utilisent des capteurs optiques, par exemple des capteurs sensibles à des rayonnements optiques qui appartiennent au domaine infrarouge, alors que les fonctionnements de tels capteurs peuvent être perturbés par des rayonnements électromagnétiques, notamment du domaine hyperfréquence. De tels rayonnements hyperfréquences peuvent en effet interagir avec des circuits électroniques qui doivent être placés à proximité immédiate des capteurs, sans pouvoir être déportés dans des volumes étanches aux rayonnements hyperfréquences provenant de l'extérieur. Il est alors connu de disposer devant un tel capteur optique, un élément de blindage qui est au moins partiellement opaque pour une partie des rayonnements hyperfréquences, tout en étant au moins partiellement transparent pour les rayonnements optiques. Pour cela, l'élément de blindage comporte en général au moins une structure bidimensionnelle qui est conductrice électriquement dans le domaine fréquentiel des hyperfréquences, en étant au moins partiellement transparente pour les rayonnements optiques.

Pour procurer une protection efficace contre les rayonnements hyperfréquences, la structure bidimensionnelle qui est conductrice dans le domaine des hyperfréquences doit en outre être reliée électriquement à une partie au moins d'une coque qui est aussi conductrice électriquement, et qui entoure le (les) capteur(s) à protéger. Cette coque peut elle-même être reliée électriquement à la masse électrique d'un support ou d'un véhicule porteur sur lequel le (les) capteur(s) optique(s) est (sont) installé(s), ou bien reliée à une borne d'une source électrique. Toutes ces connexions doivent présenter une faible impédance électrique dans le domaine des hyperfréquences pour procurer la protection voulue.

Or certains systèmes de détection complexes comportent, en plus de capteurs optiques, des capteurs de rayonnements électromagnétiques qui sont efficaces dans la bande hyperfréquence, ou à proximité de celle-ci en termes de valeurs de fréquence. Il est alors nécessaire que le même ensemble de blindage qui est utilisé pour tous les capteurs du système de détection complexe réalise un compromis entre une efficacité de blindage suffisante et un niveau de transparence pour le rayonnement hyperfréquence qui permette le fonctionnement du ou des capteur(s) de rayonnement hyperfréquence. Mais il existe des conditions dans lesquelles le rayonnement hyperfréquence qui est susceptible de traverser l'élément de blindage en provenant de l'extérieur varie dans des proportions très importantes : entre des niveaux d'intensité faibles pour lesquels l'élément de blindage doit être suffisamment transparent pour ce rayonnement hyperfréquence, et des niveaux d'intensité très élevés contre lesquels l'élément de blindage doit produire une efficacité de blindage suffisante. Une telle situation peut notamment se produire lorsque le système de détection se rapproche d'une source de rayonnement hyperfréquence, et que l'intensité de ce rayonnement hyperfréquence qui est reçue par le système de détection augmente au cours du rapprochement. Mais la source peut être analysée en utilisant aussi les capteurs qui sont sensibles dans le domaine spectral des rayonnements hyperfréquences, en plus de capteurs optiques. Pour cela, les capteurs de rayonnement hyperfréquence nécessitent que l'intensité du rayonnement hyperfréquence qui est utilisé pour analyser la source soit suffisante, surtout quand la source est encore éloignée du système de détection. Par ailleurs, la nécessité que l'ensemble de blindage soit suffisamment transparent au rayonnement hyperfréquence peut aussi être imposée par le système de détection lui-même, lorsqu'il émet du rayonnement hyperfréquence qui est susceptible de perturber son propre fonctionnement si ces rayonnements ne peuvent pas se propager vers l'extérieur. Pour ces raisons, les ensembles de blindage existants ne sont pas bien adaptés à de telles situations, notamment celles pour lesquelles l'intensité du rayonnement hyperfréquence est fortement variable en cours d'utilisation ou de mission.

Le document US2020173859A1 décrit un élément de blindage optiquement transparent.

### Problème technique

Un objectif de l'invention est alors de fournir des ensembles de blindage qui soient adaptés à des utilisations ou des missions lors desquelles le rayonnement hyperfréquence possède une intensité qui varie fortement, alors qu'une partie de ce rayonnement hyperfréquence peut être utile.

### Résumé de l'invention

Pour atteindre cet objectif ou d'autres, un premier aspect de la présente invention propose un ensemble de blindage électromagnétique transparent optiquement qui comprend :
- un substrat rigide ayant deux faces opposées, au moins partiellement transparent entre ces deux faces pour au moins un rayonnement électromagnétique qui possède une fréquence comprise entre 0,1 GHz (gigahertz) et 40 GHz, dit rayonnement hyperfréquence, et aussi au moins partiellement transparent entre les mêmes deux faces pour un rayonnement optique qui possède une longueur d'onde comprise entre 0,1 µm (micromètre) et 15 µm, ce substrat étant en outre isolant électriquement ; et
- une zone de contact électrique, qui est située à proximité d'une périphérie du substrat, et qui est destinée à être connectée électriquement à une borne de source électrique ou à une borne de masse électrique.

Selon l'invention, l'ensemble de blindage comprend en outre :
- au moins un canal, qui est agencé pour maintenir un fluide conducteur électriquement ou polarisable en contact avec la zone de contact électrique lorsque l'au moins un canal est rempli avec le fluide.
Une efficacité de blindage de l'ensemble de blindage, effective pour le rayonnement hyperfréquence qui traverse le substrat entre ses deux faces, est ainsi augmentée lorsque le fluide conducteur ou polarisable qui est contenu dans l'au moins un canal réduit une impédance électrique qui existe entre la zone de contact électrique et un point du substrat qui est distant de sa périphérie. Cette augmentation de l'efficacité de blindage apparaît par rapport à un état de l'ensemble de blindage où aucun chemin électrique qui soit constitué au moins partiellement par du fluide conducteur ou polarisable ne relie le point du substrat qui est à l'intérieur de sa périphérie à la zone de contact électrique.

Dans le cadre de la présente description, les comportements de conduction électrique et de polarisabilité du fluide, ainsi que les impédances électriques qui sont considérées, sont relatifs à la fréquence ou à une bande de fréquence qui est comprise entre 0,1 GHz et 40 GHz, et qui est ciblée par l'ensemble de blindage. De façon connue, le comportement de polarisabilité du fluide est quantifié par sa valeur de permittivité diélectrique, et des valeurs élevées de conductivité électrique et/ou des valeurs élevées de permittivité diélectrique correspondent à des valeurs faibles d'impédance électrique. L'expression de fluide conducteur ou polarisable est utilisée dans toute la présente description et les revendications pour désigner un fluide qui est conducteur sans être polarisable, ou qui est polarisable sans être conducteur, mais aussi un fluide qui est à la fois conducteur et polarisable. Par ailleurs, les transmissions et transparences optiques considérées, pour le substrat et pour une structure bidimensionnelle conductrice éventuellement utilisée, sont relatives au rayonnement optique qui est destiné à traverser le substrat.

En outre, pour toute la présente description, l'efficacité de blindage, notée EB(f) et exprimée en décibels (dB), peut être définie par EB(f) = -10·log₁₀(T(f)), où T(f) est un coefficient de transmission énergétique de l'ensemble de blindage pour le rayonnement électromagnétique hyperfréquence qui possède une fréquence f comprise entre 0,1 GHz et 40 GHz, et qui est destiné à traverser le substrat entre ses deux faces.

Selon l'invention, l'efficacité de blindage est variée en modifiant une impédance électrique qui existe entre la zone de contact électrique et un point central du substrat, ou un point qui est situé à proximité du centre du substrat. Cette impédance électrique est variée en utilisant un fluide qui est conducteur électriquement ou polarisable, et une valeur supérieure de l'efficacité de blindage est produite lorsque la connexion entre la zone de contact électrique et le point central ou situé à proximité du centre du substrat présente une valeur réduite d'impédance électrique. Ainsi, l'efficacité de blindage peut être variée au cours de l'utilisation d'un système de détection qui est équipé de l'ensemble de blindage, en temps réel et possiblement en fonction du niveau d'intensité du rayonnement hyperfréquence qui est reçu par le système de détection.

Autrement dit, le fluide conducteur ou polarisable réalise un couplage électrique variable entre la zone de contact électrique et le point qui est situé à proximité du centre du substrat. Le fluide conducteur ou polarisable peut être notamment un liquide.

Un ensemble de blindage conforme à l'invention peut former un hublot ou une fenêtre adaptée pour fermer une ouverture d'une coque qui contient le système de détection, en étant disposée devant une entrée optique d'un capteur de ce système qui est sensible au rayonnement optique. Possiblement, l'ensemble de blindage formant fenêtre ou hublot peut être adapté pour être disposé aussi et simultanément devant une entrée d'un capteur sensible à une partie du rayonnement hyperfréquence, en plus du capteur de rayonnement optique.

De façon générale, l'au moins un canal peut être réalisé dans le substrat qui est au moins partiellement transparent pour le rayonnement optique et pour le rayonnement hyperfréquence. Alternativement, l'au moins un canal peut être réalisé dans une structure qui est appliquée contre l'une des faces du substrat.

Dans des premiers modes de réalisation de l'invention, l'au moins un canal peut relier la zone de contact électrique au point du substrat qui est situé à l'intérieur de sa périphérie. Dans ce cas, l'au moins un canal peut comprendre un réseau bidimensionnel de canaux qui s'étend sur l'une des faces du substrat. Ce réseau bidimensionnel de canaux peut être à canaux parallèles, ou à canaux disposés selon une matrice carrée, rectangulaire, triangulaire, hexagonale, etc. Les canaux de ce réseau bidimensionnel peuvent aussi être agencés sans périodicité spatiale, par exemple selon une structure de Voronoï.

Dans d'autres modes de réalisation de l'invention, l'ensemble de blindage peut comprendre en outre :
- une structure bidimensionnelle fixe et conductrice électriquement, qui est disposée sur au moins une des faces du substrat, qui recouvre le point du substrat situé à l'intérieur de la périphérie, qui est séparée électriquement de la zone de contact électrique, et qui est au moins partiellement transparente pour le rayonnement optique.
L'au moins un canal est alors agencé pour que le fluide conducteur ou polarisable, lorsqu'il remplit l'au moins un canal, réduise une impédance électrique qui existe entre la zone de contact électrique et la structure bidimensionnelle fixe et conductrice. Autrement dit, le fluide établit dans ce cas un relais de faible impédance électrique entre la zone de contact électrique et la structure bidimensionnelle fixe et conductrice. L'au moins un canal peut alors être limité à une partie du substrat qui est proche de sa périphérie. Pour de tels autres modes de réalisation, la structure bidimensionnelle fixe et conductrice peut comprendre une grille d'un matériau solide conducteur électriquement, ou une couche d'un matériau solide conducteur électriquement et transparent pour le rayonnement optique, cette grille ou couche étant disposée sur au moins une des faces du substrat. Dans le cas d'une grille du matériau solide conducteur électriquement, cette grille peut être à motifs carrés, rectangulaires, triangulaires, hexagonaux, de Voronoï, etc.

Possiblement, dans des modes de réalisation de l'invention qui sont dits à contrôle par injection du fluide, l'ensemble de blindage peut comprendre en outre :
- des moyens d'injection du fluide dans l'au moins un canal ;
- un détecteur d'une intensité du rayonnement hyperfréquence, qui est situé à proximité d'une des faces du substrat ; et
- des moyens de commande, qui sont agencés pour déclencher un fonctionnement des moyens d'injection du fluide lorsque l'intensité du rayonnement hyperfréquence, mesurée par le détecteur, devient supérieure à un seuil.

Un tel ensemble de blindage peut comprendre en outre une quantité du fluide conducteur ou polarisable, ce fluide étant sélectionné parmi un métal liquide tel que du mercure, tout alliage de plusieurs métaux qui est liquide à une température d'utilisation de l'ensemble de blindage, notamment un alliage liquide à base de gallium, d'indium et d'étain, un solvant qui contient des ions dissouts ou des particules conductrices ou polarisables en suspension, notamment de l'eau salée, une solution acide, une solution basique. Alternativement, le fluide peut aussi être un liquide polarisable, tel que de l'eau pure, un alcool, une cétone, ou un mélange de ceux-ci tel qu'un mélange d'eau et d'éthanol dans des proportions massiques de 50%-50%, etc.

Alternativement, d'autres modes de réalisation de l'invention peuvent utiliser un contrôle d'une transition d'état du fluide conducteur ou polarisable. Dans ce cas, l'ensemble de blindage peut comprendre en outre une quantité du fluide conducteur ou polarisable, ce fluide étant sélectionné pour présenter une transition entre deux états, ces états étant associés à des valeurs respectives de conductivité électrique du fluide qui sont différentes, et/ou à des valeurs respectives de permittivité diélectrique du fluide qui sont différentes. L'ensemble de blindage peut alors comprendre en outre :
- des moyens de modification du fluide, qui sont adaptés pour faire passer le fluide d'un des deux états à l'autre ;
- un détecteur d'une intensité du rayonnement hyperfréquence, qui est situé à proximité d'une des faces du substrat ; et
- des moyens de commande, qui sont agencés pour déclencher un fonctionnement des moyens de modification du fluide lorsque l'intensité du rayonnement hyperfréquence, mesurée par le détecteur, devient supérieure à un seuil.

Dans tous ces cas, le détecteur d'intensité du rayonnement hyperfréquence et les moyens de commande peuvent permettre un fonctionnement automatique de l'ensemble de blindage, pour modifier son efficacité de blindage, en particulier pour l'augmenter.

Notamment, les moyens de modification du fluide peuvent être des moyens de chauffage et/ou de refroidissement qui sont agencés pour modifier une température de ce fluide, ou des moyens de modification d'une composition du fluide. Dans le cas de moyens de chauffage et/ou de refroidissement, les deux états du fluide sont distingués par sa température, et par les variations de sa conductivité électrique et/ou de sa permittivité diélectrique qui sont corrélées aux variations de sa température. Il est ainsi possible de varier finement l'efficacité de blindage en fonction du besoin, en contrôlant et en ajustant la température du fluide. Eventuellement, les moyens de modification du fluide peuvent être adaptés pour modifier une phase du fluide. Par exemple, des moyens de refroidissement peuvent faire passer le fluide d'une phase gazeuse à une phase liquide, ou d'une phase liquide à une phase solide, ou des moyens de chauffage peuvent faire passer le fluide d'une phase solide à une phase liquide, ou d'une phase liquide à une phase gazeuse, lorsque ces changements de phase produisent des modifications appropriées de l'impédance électrique qui existe entre la zone de contact électrique et le point du substrat qui est situé à l'intérieur de la périphérie.

Un deuxième aspect de l'invention propose un système de détection qui comprend :
- un capteur optique, qui est sensible au rayonnement optique ;
- au moins une partie d'une coque conductrice électriquement, qui entoure le capteur optique et qui comporte une ouverture ; et
- un ensemble de blindage qui est conforme au premier aspect de l'invention, avec le substrat de cet ensemble de blindage qui est disposé devant une entrée optique du capteur optique en fermant l'ouverture de la partie de coque.
La zone de contact électrique de l'ensemble de blindage est alors connectée électriquement à la partie de coque.

Enfin, un troisième aspect de l'invention propose un véhicule porteur qui comprend un système de détection conforme au deuxième aspect de l'invention. Un tel véhicule porteur peut notamment être de type aérien, terrestre ou maritime.

### Brève description des figures

Les caractéristiques et avantages de la présente invention apparaîtront plus clairement dans la description détaillée ci-après d'exemples de réalisation non-limitatifs, en référence aux figures annexées parmi lesquelles :
[Fig. 1] représente un système de détection auquel l'invention est appliquée ;
[Fig. 2] montre un mode de réalisation alternatif pour un ensemble de blindage tel qu'utilisé dans le système de détection de [Fig. 1] ;
[Fig. 3] est une vue en plan d'un hublot pouvant faire partie d'un ensemble de blindage conforme à l'invention ;
[Fig. 4] est une vue en plan d'une première variante de réalisation du hublot de [Fig. 3] ;
[Fig. 5] est une vue en plan d'une seconde variante de réalisation du hublot de [Fig. 3] ;
[Fig. 6a] est une vue en coupe schématique de la première variante de réalisation de hublot de [Fig. 4] ;
[Fig. 6b] est un diagramme spectral d'efficacité de blindage pour la première variante de réalisation de hublot de [Fig. 4], établi pour plusieurs fluides polarisables ; et
[Fig. 7] montre un véhicule porteur aérien de type drone qui est conforme à l'invention.

### Description détaillée de l'invention

Pour raison de clarté, les dimensions des éléments qui sont représentés dans ces figures ne correspondent ni à des dimensions réelles ni à des rapports de dimensions réels. En outre, des références identiques qui sont indiquées dans des figures différentes désignent des éléments identiques ou qui ont des fonctions identiques.

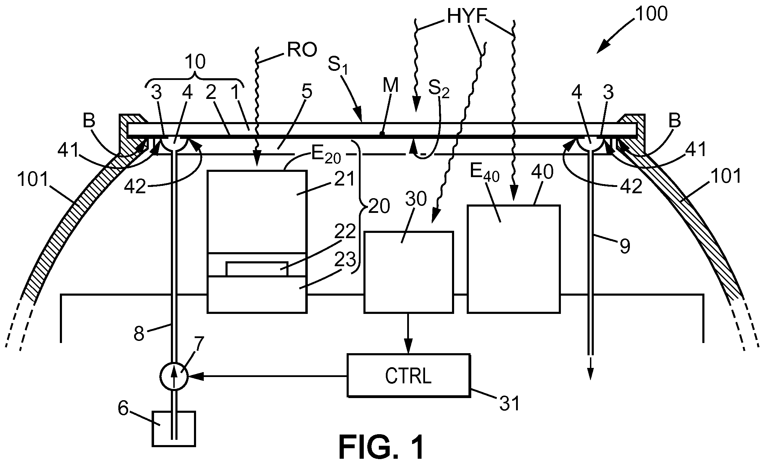

Conformément à [Fig. 1], un système de détection 100 comporte une partie de coque 101, un ensemble de blindage 10 et au moins un capteur optique 20. Il peut comprendre en outre optionnellement un capteur de rayonnement hyperfréquence 40 et un détecteur de rayonnement hyperfréquence 30, qui seront décrits plus loin.

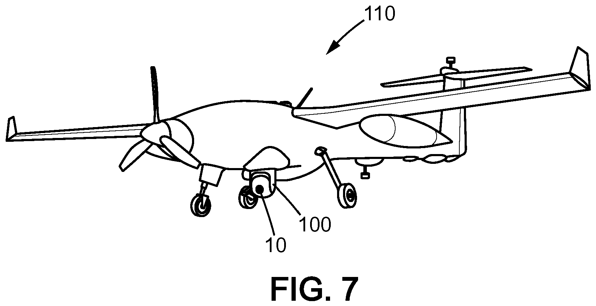

Par exemple, le système de détection 100 peut avoir une configuration de boule optronique mobile, et être destiné à être embarqué à bord d'un véhicule porteur. Possiblement, les capteurs du système de détection 100, dont le capteur optique 20 et aussi éventuellement le capteur de rayonnement hyperfréquence 40, peuvent participer à détecter un élément de scène externe. [Fig. 7] montre un drone 110 qui est muni du système de détection 100.

La partie de coque 101 est conductrice électriquement, par exemple constituée en un matériau métallique ou en un matériau composite à base de fibres de carbone. Elle constitue une masse électrique qui peut être considérée comme une référence de potentiel électrique. En outre, la partie de coque 101 entoure le capteur optique 20, avec le capteur de rayonnement hyperfréquence 40 et/ou le détecteur de rayonnement hyperfréquence 30, le cas échéant, en formant une cavité dans laquelle se trouve(nt) ce(s) capteur(s) et/ou détecteur. Ainsi, la portion de coque 101, en dehors de l'ensemble de blindage 10, constitue un écran opaque pour les rayonnements hyperfréquences qui proviennent de l'extérieur.

Le capteur optique 20 est sensible à du rayonnement optique RO dans la bande de longueur d'onde qui est comprise entre 0,1 µm et 15 µm. Ce peut être un capteur d'images, qui comporte de façon connue un objectif 21, un détecteur d'images 22, par exemple du type détecteur d'images matriciel, et une électronique de proximité 23. L'électronique de proximité 23 est destinée notamment à contrôler le fonctionnement du détecteur d'images 22, et à transmettre les signaux de lecture d'images qui sont délivrés par ce dernier, à une unité de traitement déportée (non représentée). Le fonctionnement de l'électronique de proximité 23 peut être perturbé par du rayonnement hyperfréquence HYF, dans la bande de fréquence comprise entre 0,1 GHz et 40 GHz, qui pénétrerait dans la partie de coque 101. En effet, l'entrée optique E₂₀ du capteur optique 20 est nécessairement exposée vers l'extérieur pour recueillir le rayonnement optique RO qui provient de l'élément de scène, mais cette exposition s'applique aussi au rayonnement hyperfréquence HYF, qui peut perturber le fonctionnement du système de détection 100, y compris si ce rayonnement hyperfréquence HYF ne provient pas de l'élément de scène qui est visé.

Pour éviter les effets de telles perturbations, notamment sur l'électronique de proximité 23, l'ensemble de blindage 10 est conçu pour être au moins partiellement opaque au rayonnement hyperfréquence HYF, tout en étant au moins partiellement transparent pour le rayonnement optique RO. Toutefois, une efficacité de blindage trop importante pour l'ensemble de blindage 10 peut ne pas être souhaitée pendant une certaine phase de l'utilisation du système de détection 100. Pour cette raison, la présente invention propose une amélioration de l'ensemble de blindage 10 qui permet d'en modifier l'efficacité de blindage, par exemple automatiquement pendant l'utilisation du système de détection 100. Une telle modification automatique de l'efficacité de blindage de l'ensemble 10, en temps réel pendant son utilisation, peut être utile en particulier lorsque le système de détection 100 comprend le capteur de rayonnement hyperfréquence 40, pour le fonctionnement duquel la réception d'une partie suffisante du rayonnement hyperfréquence HYF est néanmoins nécessaire, mais sans provoquer de saturation ni de dégradation par surexposition. Selon un contexte d'utilisation possible, l'intensité du rayonnement hyperfréquence HYF peut être faible pendant une première phase de l'utilisation, de sorte qu'une efficacité de blindage faible est alors souhaitée, pour permettre un bon fonctionnement du capteur 40. Une telle efficacité de blindage qui est faible peut aussi éviter que du rayonnement hyperfréquence qui est produit par le système de détection 100 lui-même reste concentrée sur ce système de détection, jusqu'à risquer d'en perturber le fonctionnement. Puis, pendant une phase suivante de l'utilisation, l'intensité du rayonnement hyperfréquence HYF peut devenir trop importante, si bien qu'une efficacité de blindage augmentée est alors nécessaire. Mais l'ensemble de blindage 10 doit rester suffisamment transparent pour le rayonnement optique RO pendant les deux phases d'utilisation, afin de permettre un fonctionnement correct du capteur optique 20.

L'ensemble de blindage 10 peut former un hublot de fermeture de la partie de coque 101, qui est disposé devant l'entrée optique E₂₀ du capteur optique 20, et éventuellement aussi devant l'entrée de rayonnement E₄₀ du capteur de rayonnement hyperfréquence 40, et éventuellement en plus devant le détecteur de rayonnement hyperfréquence 30.

L'ensemble de blindage 10 comprend un substrat 1 qui est transparent au rayonnement optique RO et au rayonnement hyperfréquence HYF, entre deux faces opposées de ce substrat 1 qui sont notées S₁ et S₂. Un tel substrat peut être à base de silicium (Si), de germanium (Ge), d'arséniure de gallium (GaAs), de sulfure de zinc (ZnS), de silice (SiO₂), d'oxyde d'aluminium (Al₂O₃) ou d'oxyde de magnésium (MgO), etc., de façon non-limitative. Lorsque le substrat 1 possède une géométrie circulaire, un diamètre de celui-ci peut être compris entre 5 cm (centimètre) et 50 cm, par exemple.

Il est précisé que, de façon générale pour l'invention, l'ensemble de blindage 10 n'est pas limité à une géométrie circulaire, mais qu'il peut alternativement posséder une géométrie carrée, rectangulaire, elliptique, etc. sans limitation de forme. Lorsque cette géométrie est circulaire, la périphérie du substrat 1 désigne sa circonférence.

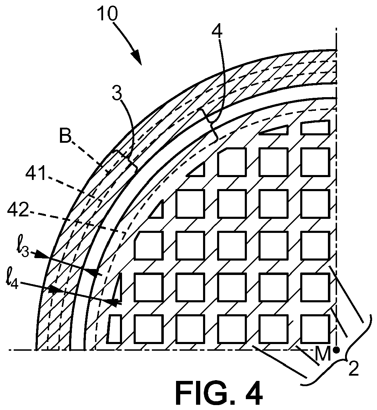

Dans les modes de réalisation illustrés par [Fig. 1]-[Fig. 4], le substrat 1 porte une structure bidimensionnelle 2 qui est conductrice électriquement et fixe, sur l'une au moins de ses faces S₁ et S₂, par exemple la face S₂, pour produire l'efficacité de blindage électromagnétique. La structure bidimensionnelle 2 est conçue pour être transparente pour le rayonnement optique RO, et pour être conductrice électriquement dans une mesure qui est adaptée pour produire un effet de blindage à l'encontre du rayonnement hyperfréquence HYF. Pour cela, la structure bidimensionnelle 2 peut avoir l'une des configurations suivantes, qui sont citées à titre d'exemples non-limitatifs :
- au moins une couche mince d'un métal, par exemple une couche d'argent (Ag), qui peut être intercalée entre deux couches diélectriques transparentes pour le rayonnement optique RO, les deux couches diélectriques ayant pour but de réduire la réflexion du rayonnement optique RO par rapport à la couche métallique seule ;
- au moins une couche d'un oxyde transparent et conducteur, par exemple une couche d'oxyde d'indium dopé à l'étain (ITO), éventuellement associée à au moins une autre couche diélectrique et transparente pour le rayonnement RO, encore dans le but de réduire la réflexion du rayonnement optique RO par rapport à la couche d'oxyde transparent conducteur seule ;
- une grille d'un matériau conducteur électriquement, par exemple une grille de cuivre (Cu) ou d'argent (Ag), qui est constituée de rubans imprimés ou de fils du matériau conducteur, et avec laquelle le substrat 1 est dépourvu du matériau conducteur électriquement entre les rubans ou fils de la grille. Eventuellement, le matériau conducteur de la grille peut être superposé à un matériau d'accrochage sur le substrat 1, et possiblement recouvert en outre d'un matériau de protection, notamment de protection contre la corrosion, par exemple une surcouche de titane (Ti). En général, les rubans ou fils d'une telle grille sont opaques pour le rayonnement optique RO, et la transparence pour le rayonnement optique RO résulte d'un taux de couverture du substrat 1 par les rubans ou fils de la grille, qui est limité. Par exemple, ce taux de couverture peut être compris entre 10% et 50%, un pas de rubans ou de fils dans la grille peut être compris entre 1 µm (micromètre) et 10 mm (millimètre), et la grille peut avoir un motif carré. Toutefois d'autres motifs de grille sont également possibles : rectangulaires, triangulaires, octogonaux, de Voronoï, etc. La grille du matériau conducteur électriquement peut être associée à au moins une couche diélectrique et transparente pour le rayonnement RO, possiblement encore dans le but de réduire la réflexion du rayonnement optique RO par rapport au substrat 1 seul, mais aussi comme protection contre la corrosion de la grille métallique.

Eventuellement, la structure bidimensionnelle 2 peut aussi être constituée d'une grille dont les rubans ou fils sont chacun transparents optiquement, en étant à base d'une ou plusieurs couche(s) mince(s) d'un métal qui est (sont) intercalée(s) entre des couches diélectriques, ou en étant à base d'un oxyde transparent et conducteur.

De telles structures bidimensionnelles 2 peuvent être réalisées sur le substrat 1 par l'un des procédés de dépôt de matériaux connus de l'Homme du métier, tel que la pulvérisation cathodique, l'évaporation, le dépôt chimique en phase vapeur, le dépôt électrolytique, possiblement en combinaison avec une ou plusieurs étapes de masquage ou de gravure.

Les configurations qui viennent d'être citées pour la structure bidimensionnelle 2 sont connues, si bien qu'il n'est pas nécessaire de les décrire plus ici. Elles peuvent avoir chacune une résistance par carré qui est comprise entre 10⁻² ohm par carré et 20 ohm par carré, par exemple. Toutefois, et d'une façon générale pour l'invention, la partie de coque 101 possède préférablement une valeur de résistance par carré qui est inférieure à celle de la structure bidimensionnelle 2. Ainsi, la fonction de masse électrique ou de référence de potentiel électrique est réalisée dans une meilleure mesure par la partie de coque 101 vis-à-vis de la structure bidimensionnelle 2.

De façon connue aussi, la structure bidimensionnelle 2 doit être connectée à la partie de coque 101 avec une faible valeur d'impédance électrique de connexion pour produire une protection de blindage qui soit efficace. Au moins une zone de contact électrique 3 est prévue sur le substrat 1, au niveau de sa périphérie, d'une façon adaptée pour que cette zone de contact électrique 3 soit connectée électriquement à la partie de coque 101, avec une résistance électrique de connexion qui est faible ou minimale. Par exemple, la zone de contact électrique 3 peut être une portion additionnelle de structure bidimensionelle conductrice, qui est séparée sur la face S₂ par rapport à la structure 2, et disposée pour venir en contact électrique avec la partie de coque 101 lorsque le substrat 1 est assemblé avec cette dernière. Alternativement, la zone de contact électrique 3 peut être raccordée électriquement à la partie de coque 101 lors d'une opération de reprise dédiée. Par exemple, au moins une borne électrique peut être fixée sur la zone de contact électrique 3, par l'une des techniques connues telles qu'une soudure de surface ou un pincement avec un doigt de contact qui est conducteur électriquement. Puis cette borne électrique est raccordée à la portion de coque 101 par une des multiples méthodes connues, y compris l'enfichage ou le vissage d'une borne supplémentaire dans la partie de coque 101, le contact sous pression avec ou sans déformation élastique, etc.

Alors, l'efficacité de blindage dépend de la valeur faible ou élevée de l'impédance électrique de la connexion entre la structure bidimensionnelle conductrice 2 et chaque zone de connexion électrique 3. Selon l'invention, un canal 4 est prévu pour être rempli par un liquide, de sorte que le liquide soit alors en contact d'une part avec la structure bidimensionnelle conductrice 2, et d'autre part avec la zone de contact électrique 3. Par exemple, un tel canal peut s'étendre continûment autour de la structure bidimensionnelle conductrice 2, parallèlement à la périphérie du substrat 1. Dans le mode de réalisation qui est montré dans [Fig. 1], le canal 4 est formé dans une plaque 5 qui est appliquée sur la face S₂ du substrat 1. Cette plaque 5 est constituée d'un matériau isolant électriquement et non-polarisable, mais transparent au rayonnement optique RO et aussi transparent au rayonnement hyperfréquence HYF. Elle peut être en polycarbonate, par exemple. De préférence, elle peut être collée sur la face S₂ du substrat 1 en dehors du canal 4. La liaison entre la plaque 5 et la face S₂ du substrat 1 est étanche, de sorte que le liquide reste contenu dans le canal 4 sans fuite ni infiltration entre la plaque 5 et la zone de contact électrique 3, ni entre la plaque 5 et la structure bidimensionnelle conductrice 2. Comme montré dans [Fig. 1], la zone de contact électrique 3 et la structure bidimensionnelle conductrice 2 peuvent chacune déborder partiellement dans la section du canal 4, en restant distantes l'une de l'autre, afin que le liquide contenu dans le canal 4 soit en contact simultanément avec l'une et avec l'autre.

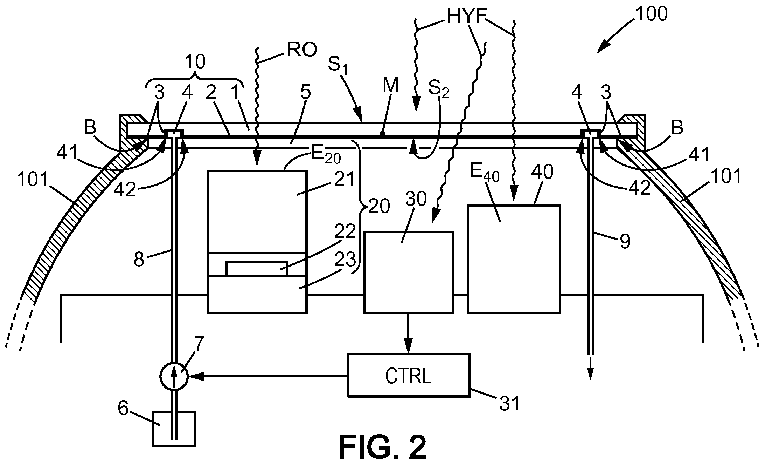

[Fig. 2] montre un mode de réalisation alternatif où le canal 4 est formé dans le substrat 1, par exemple par usinage, et fermé par la plaque 5 qui peut alors avoir une épaisseur uniforme. Le matériau de la plaque 5 possède les mêmes propriétés que dans le mode de réalisation de [Fig. 1], et la plaque 5 peut encore être collée sur la face S₂ du substrat 1 en dehors du canal 4. Dans le cas du mode de réalisation de [Fig. 2], la zone de contact électrique 3 et la structure bidimensionnelle conductrice 2 peuvent chacune se prolonger sur les parois latérales opposées du canal 4, à l'intérieur de celui-ci, alors que le fond du canal 4 est isolant électriquement et non-polarisable.

Pour réaliser la connexion à faible impédance électrique entre la structure bidimensionnelle conductrice 2 et chaque borne de contact électrique 3, le liquide qui est injecté dans le canal 4 pour le remplir est conducteur électriquement ou polarisable. Dans le cas d'un liquide conducteur, ce peut être par exemple un métal liquide tel que du mercure (Hg), un solvant dans lequel une quantité suffisante d'ions a été dissoute, comme de l'eau salée, une solution acide, une solution basique, un liquide qui contient des particules conductrices électriquement en suspension, ou un alliage liquide de métaux tel que du Galinstan^{®}, qui est à base d'un mélange de gallium (Ga), d'indium (In) et d'étain (Sn). Dans le cas d'un liquide polarisable, caractérisé par une valeur élevée de permittivité diélectrique, ce peut être par exemple de l'eau pure, des alcools, des cétones, ou des mélanges de ces liquides, sans que cette liste soit exhaustive. Par exemple, le liquide est contenu initialement dans un réservoir 6, qui est raccordé à au moins un endroit du canal 4 par une pompe 7 et un conduit fluidique d'injection 8. Pour le mode de réalisation décrit présentement, le réservoir 6, la pompe 7 et le conduit fluidique d'injection 8 constituent les moyens d'injection du fluide au sens de la partie générale de la présente description. En fonction du fluide qui est utilisé, une température de l'ensemble de blindage 10 peut être maintenue à l'intérieur d'un intervalle de fonctionnement de cet ensemble. Par exemple, lorsque le fluide doit être dans l'état liquide, un système de refroidissement peut être nécessaire en fonction de l'application de l'ensemble de blindage 10, pour éviter que le liquide ne s'évapore lorsque la température du substrat 1 dépasse la température de vaporisation de ce liquide. De même, un système de réchauffage peut être nécessaire pour éviter que le liquide ne se solidifie lorsque la température du substrat 1 devient inférieure à la température de solidification du liquide. Ainsi, lorsque le fluide est constitué du mélange d'eau et d'éthanol en proportions massiques de 50%-50%, la température de vaporisation est supérieure à +80°C et la température de solidification est inférieure à - 40°C. Ces valeurs sont donc compatibles avec un intervalle de fonctionnement pour l'ensemble de blindage 10 qui est compris entre -40°C et +70°C, comme pour des applications aéronautiques de l'invention. Mais si de l'eau pure est utilisée en tant que fluide polarisable à la place de ce mélange, la température de solidification qui est alors égale à 0°C rend nécessaire de prévoir un système de réchauffage de l'ensemble de blindage 10. Pour d'autres applications où la température d'utilisation de l'ensemble de blindage 10 peut dépasser 80°C, un système de refroidissement sera à prévoir si le mélange d'eau et d'éthanol en proportions massiques de 50%-50% est utilisé.

Le canal 4 peut être initialement soit vide de liquide, soit rempli avec un liquide isolant et non-polarisable. Autrement dit, le canal 4 peut être rempli initialement avec un fluide à valeur faible de conductivité électrique et à valeur faible de permittivité diélectrique. Dans cet état initial, l'efficacité de blindage est faible, puisque la structure bidimensionnelle conductrice 2 présente une impédance électrique de liaison qui est élevée vis-à-vis de la partie de coque 101. Puis le liquide conducteur ou polarisable est injecté par la pompe 7 dans le canal 4, établissant une faible valeur d'impédance électrique de liaison entre la structure bidimensionnelle conductrice 2 et la zone de contact électrique 3, et par conséquent avec partie de coque 101. L'efficacité de blindage est ainsi augmentée par rapport à l'état initial. Le déclenchement de la pompe 7 peut être activé par un contrôleur approprié 31 (voir [Fig. 1]), noté CTRL, en fonction d'un niveau d'intensité qui peut être mesuré par le détecteur 30 pour le rayonnement hyperfréquence HYF.

De façon connue, une évacuation 9 peut être prévue à un endroit du canal 4 qui est opposé à la connexion du conduit fluidique d'injection 8, afin d'évacuer un gaz ou un liquide isolant électriquement et à faible valeur de permittivité diélectrique qui est présent initialement dans le canal 4, et permettre son remplacement par le liquide conducteur ou polarisable. Un traitement de mouillage approprié peut aussi être appliqué aux parois du canal 4, afin de faciliter l'injection de chaque liquide. Enfin, le canal 4 peut avoir une section de faibles dimensions, pour ne pas réduire l'ouverture de la partie de coque 101 par rapport à la pénétration des rayonnements optique RO et hyperfréquence HYF.

Le substrat 1, la zone de contact électrique 3 et le canal 4 constituent l'ensemble de blindage 10 au sens de la présente invention. De façon générale, l'injection du liquide conducteur ou polarisable dans le canal 4 permet d'établir une connexion à faible impédance électrique entre la zone de contact électrique 3 et un point M qui est situé dans une zone centrale du substrat 1 à distance de sa périphérie et de la zone de contact électrique 3.

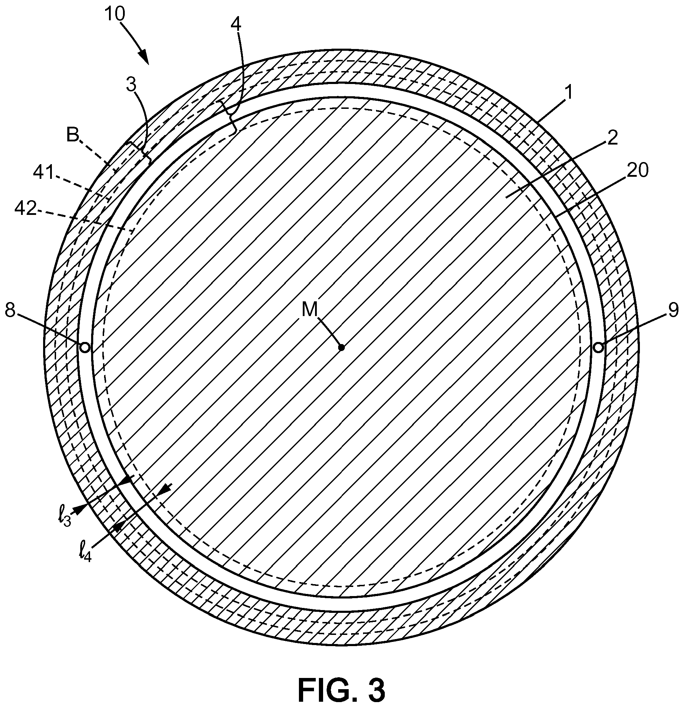

[Fig. 3] est une vue en plan de l'ensemble de blindage 10 du mode de réalisation de [Fig. 1]. La zone de contact électrique 3 peut être en forme de bande circulaire le long de la périphérie du substrat 1. Sa largeur de bande I₃ peut être adaptée pour que cette zone de contact électrique 3 s'étende de part et d'autre d'un bord B de la partie de coque 101 qui limite l'entrée des rayonnements RO et HYF en direction des capteurs 20 et 40, et éventuellement aussi du détecteur 30. Dans le mode de réalisation représenté, le bord B de la partie de coque 101, celle-ci étant conductrice électriquement, est en contact direct avec la zone de contact électrique 3. La largeur de bande is est aussi adaptée pour que la zone de contact électrique 3 déborde au-delà de la paroi latérale externe 41 du canal 4. Par ailleurs, la couche conductrice continue qui constitue la structure bidimensionnelle 2 peut avoir une limite périphérique 20 qui est parallèle à la paroi latérale externe 41 du canal 4, et qui déborde au-delà de la paroi latérale interne 42 du canal 4, sans atteindre la zone de contact électrique 3. Par exemple, le canal 4 peut avoir une largeur I₄ de 2 mm (millimètre), alors que la zone de contact électrique 3 et la structure bidimensionnelle 2 débordent chacune de 0,5 mm à l'intérieur du canal 4.

[Fig. 4] correspond à une partie de [Fig. 3], lorsque la structure bidimensionnelle fixe et conductrice 2 est constituée par une grille de matériau solide et conducteur électriquement, par exemple une grille à motif carré. Dans ce cas, la grille est constituée de fils conducteurs qui sont parallèles chacun à l'une ou l'autre de deux directions perpendiculaires. Alternativement, mais d'une façon qui est moins préférée à cause de valeurs plus faibles qui sont alors obtenues pour l'efficacité de blindage, la grille de la structure bidimensionnelle conductrice 2 peut être constituée de fils qui sont parallèles à une seule direction, en étant équidistants entre fils voisins. L'Homme du métier sait déterminer, pour les deux configurations de [Fig. 3] et [Fig. 4], les caractéristiques de couche conductrice ou la largeur des fils et leur espacement pour obtenir une valeur voulue d'efficacité de blindage. Typiquement, une augmentation de l'efficacité de blindage EB(f) qui est supérieure à 10 dB a été obtenue pour la valeur de fréquence f égale à 10 GHz, entre un premier instant où le canal 4 était vide de liquide conducteur ou polarisable, et un second instant après que le canal 4 a été rempli avec du liquide conducteur ou polarisable.

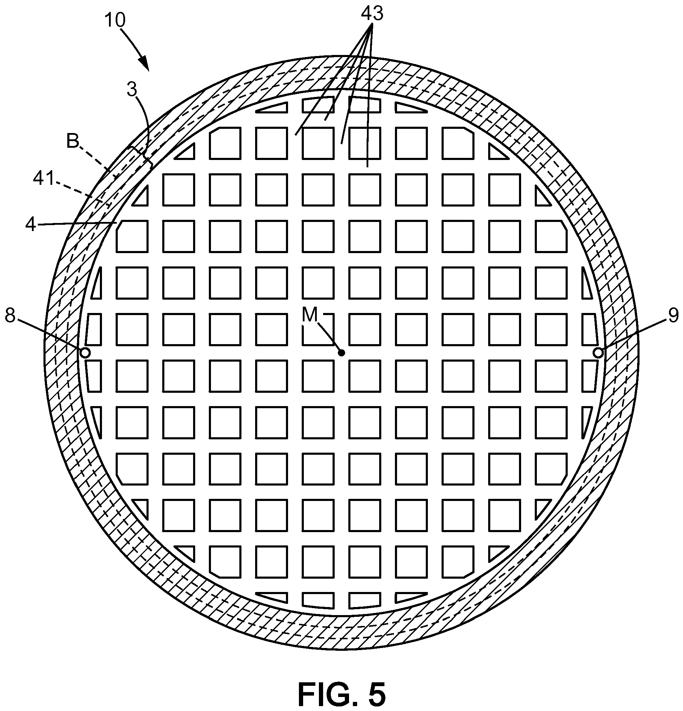

[Fig. 5] montre encore un autre mode de réalisation de l'invention, dans lequel un réseau bidimensionnel de canaux remplace la structure bidimensionnelle 2 constituée de matériau conducteur solide. Le réseau bidimensionnel de canaux s'étend à partir du canal périphérique 4, sous forme de canaux secondaires 43 qui peuvent former un motif quelconque dans la face S₂ du substrat 1. Par exemple, les canaux secondaires 43 peuvent être parallèles chacun à l'une ou l'autre de deux directions perpendiculaires, en formant un motif carré. Alternativement, mais d'une façon qui est moins préférée à cause de valeurs plus faibles qui sont alors obtenues pour l'efficacité de blindage, les canaux secondaires 43 peuvent être parallèles à une seule direction, en étant équidistants entre canaux voisins. Le conduit fluidique d'injection 8 et l'évacuation 9 sont positionnés de préférence pour favoriser une pénétration progressive du liquide dans tout le réseau bidimensionnel des canaux secondaires 43 à partir du canal périphérique 4. Pour un tel mode de réalisation, le liquide conducteur ou polarisable n'a plus seulement un rôle de connecteur à basse impédance électrique, mais a en plus le rôle d'un matériau qui produit lui-même la fonction de blindage. Pour produire cette fonction, il génère une valeur faible d'impédance électrique entre la zone de contact électrique 3 et au moins un point M qui est situé dans une zone centrale du substrat 1 à distance de la zone de contact électrique 3. Comme pour le canal périphérique 4, les canaux secondaires 43 peuvent être formés alternativement dans la plaque 5 ou dans le substrat 1. De tels modes de réalisation de l'invention, conformes à [Fig. 5] sont de préférence réalisés avec un liquide qui est conducteur électriquement.

Dans des variantes de réalisation de l'invention, la structure bidimensionnelle fixe et conductrice 2 ou le réseau bidimensionnel des canaux secondaires 43 peut être limité(e) à une zone restreinte dans la face S₂ du substrat 1, en vis-à-vis de celui ou ceux des capteurs 20, 40 qui nécessite(nt) d'être protégé(s) contre des valeurs d'intensité trop élevées du rayonnement hyperfréquence HYF. La structure bidimensionnelle conductrice 2 ou le réseau bidimensionnel des canaux secondaires 43 qui est fourni(e) à l'intérieur de cette zone restreinte peut alors n'être relié(e) que par quelques fils conducteurs ou canaux secondaires au canal périphérique 4, afin d'assurer que la variation d'efficacité de blindage soit effective pour le ou les capteur(s) à protéger. La transparence de l'ensemble de blindage 10 aux rayonnements optique RO et hyperfréquence HYF en dehors de cette zone restreinte peut ainsi être maximale.

A l'inverse, dans d'autres variantes de réalisation de l'invention, la structure bidimensionnelle fixe et conductrice 2 telle que décrite en référence à [Fig. 3] ou [Fig. 4], ou le réseau bidimensionnel des canaux secondaires 43 tel que décrit en référence à [Fig. 5], peut être supprimé(e) d'une zone restreinte dans la face S₂ du substrat 1, qui est en vis-à-vis d'un capteur ne nécessitant pas d'être protégé contre des valeurs d'intensité trop élevées du rayonnement hyperfréquence HYF. Une telle autre variante est surtout appropriée lorsque le fonctionnement du capteur concerné est amélioré si l'intensité du rayonnement optique RO ou hyperfréquence HYF qu'il reçoit, est supérieure.

Dans encore d'autres variantes de réalisation de l'invention, le liquide qui remplit la canal 4 et/ou le réseau des canaux secondaires 43 peut présenter une transition d'état, entre un premier état qui est isolant électriquement et non-polarisable, et un second état qui est conducteur électriquement ou polarisable. Ainsi, le premier état est associé à une valeur élevée de résistivité électrique avec une valeur faible de permittivité diélectrique, alors que le second état est associé à une autre valeur de résistivité électrique du liquide qui est inférieure à celle du premier état, et/ou une autre valeur de permittivité diélectrique du second état qui est supérieure à celle du premier état. Une transition entre les deux états peut être contrôlée par la température du liquide. Alors, l'ensemble de blindage 10 peut comprendre en outre des moyens de modification du liquide, qui sont adaptés pour faire passer ce liquide du premier état au second état, ou l'inverse éventuellement. Dans le cas d'une transition d'état qui est contrôlée par la température, le substrat 1 peut être muni d'un élément chauffant, par exemple distribué sur l'une de ses faces, tel qu'une couche chauffante. Dans ce cas, le liquide peut être contenu de façon permanente et statique dans les canaux 4 et/ou 43, et l'efficacité de blindage est variée en déclenchant une alimentation électrique de l'élément chauffant. Alternativement, le liquide peut être chauffé à l'extérieur des canaux 4 et 43, par un élément chauffant qui est disposé autour du conduit d'alimentation fluidique 8. Dans ce cas, l'évacuation 9 est connectée à l'entrée de la pompe 7 pour établir une circulation du liquide en boucle fermée. Pour de telles variantes de réalisation de l'invention où le liquide présente une transition d'état qui est activée thermiquement, avec variation de sa conductivité électrique et/ou de sa permittivité diélectrique, un fonctionnement de l'élément chauffant et éventuellement aussi de la pompe 7 peut encore être déclenché par le contrôleur 31, en fonction du signal de mesure qui est délivré par le détecteur 30.

Alternativement à un mode d'activation thermique pour la transition du liquide entre le premier état et le second état, il est possible de contrôler cette transition en modifiant la composition de ce liquide. Par exemple, le liquide peut présenter une composition initiale qui est isolante électriquement et non-polarisable, et la transition peut être provoquée en injectant dans cette composition initiale une composante additionnelle de composition qui est conductrice électriquement et/ou polarisable. De préférence, cette composante additionnelle de composition est miscible dans le liquide à partir de sa composition initiale. Plusieurs pompes peuvent alors être utilisées pour varier ainsi la composition du liquide.

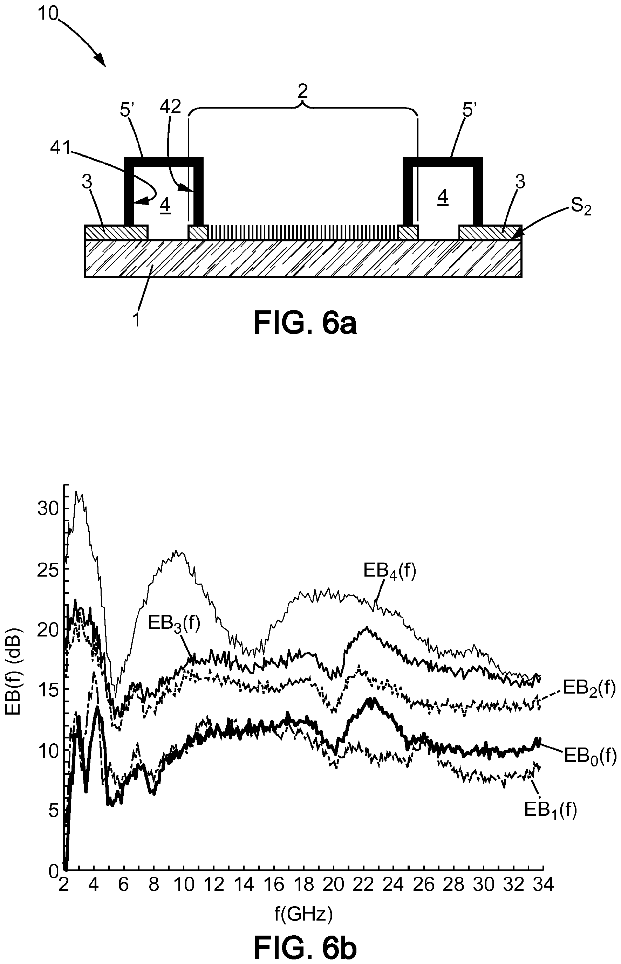

[Fig. 6a] correspond au mode de réalisation de [Fig. 4] qui a été décrit plus haut. Le substrat 1 est formé par une plaque de verre clair, carrée et de dimensions telles que la structure bidimensionnelle 2 occupe une surface carrée d'environ 50 mm x 50 mm. Dans ce mode de réalisation, la structure bidimensionnelle 2 est formée par une couche d'argent (Ag) qui est gravée pour constituer une grille à motif carré. Le pas de cette grille, de l'ordre d'un à quelques micromètres, et la largeur de ses fils sont sélectionnés pour qu'elle possède une transmission optique qui est comprise entre 80% et 86% sur tout l'intervalle de longueur d'onde compris entre 0,400 µm et 1,100 µm pour le rayonnement optique. En dehors de cet intervalle spectral pour le rayonnement optique, la transparence optique de l'ensemble de blindage 10 est déterminée par le substrat de verre. Le canal 4 est constitué par une gouttière 5' qui est appliquée sur le substrat 1 de façon étanche, avec un rebord interne 42 de la gouttière 5' qui est collé sur la structure bidimensionnelle 2 à distance de la limite périphérique externe de celle-ci, et un rebord externe 41 de la gouttière 5' qui est collé sur la zone de contact électrique 3 à distance de la limite interne de cette zone. De cette façon, un liquide polarisable qui est injecté dans le canal 4 ainsi formé établit un contact électrique à impédance réduite entre la structure bidimensionnelle 2 et la zone de contact électrique 3. A titre d'exemple, la gouttière 5' peut être réalisée en acide polylactique par impression tridimensionnelle, ou impression 3D, mais d'autres matériaux de gouttière et d'autres technologies de fabrication peuvent être utilisés alternativement. Le diagramme de [Fig. 6b] montre les valeurs d'efficacité de blindage EB(f) qui sont obtenues pour un tel ensemble de blindage 10, en fonction de la fréquence f entre 2 GHz et 34 GHz, pour les conditions d'utilisation suivantes :
courbe EB₀(f) : vide ou air sec dans le canal 4,
courbe EB₁(f) : canal 4 rempli d'une huile organique à faible valeur de permittivité diélectrique,
courbe EB₂(f) : canal 4 rempli d'éthanol, à valeur moyenne de permittivité diélectrique,
courbe EB₃(f) : canal 4 rempli d'un mélange de 50%ᵥₒₗ. d'éthanol et de 50%ᵥₒₗ. d'eau, et
courbe EB₄(f) : canal 4 rempli d'eau ultrapure, à valeur de permittivité diélectrique qualifiée comme étant élevée.
Ces courbes montrent que l'efficacité de blindage est d'autant plus élevée que le milieu qui est présent à l'intérieur du canal 4 possède une valeur élevée de permittivité diélectrique. Ainsi, l'eau ultrapure (courbe EB₄(f)), qui possède une valeur de permittivité diélectrique supérieure à celles de l'huile organique utilisée et de l'éthanol, procure un gain moyen de plus de 22 dB pour l'efficacité de blindage à 34 GHz par rapport à une condition d'utilisation de l'ensemble de blindage 10 où le canal 4 est vide (courbe EB₀(f)). Ces courbes montrent en outre qu'il est possible d'ajuster l'efficacité de blindage à un niveau désiré en utilisant un liquide approprié pour remplir le canal 4, ce liquide pouvant être un mélange contrôlé de plusieurs composantes dont les valeurs respectives de permittivité diélectrique sont différentes. Les inventeurs soulignent que l'invention, consistant à utiliser un fluide conducteur ou polarisable pour établir une liaison électrique à faible impédance, est efficace dans un domaine spectral, notamment pour des valeurs de la fréquence f qui sont supérieures à 15 GHz, où l'utilisation de composants électroniques localisés, tels que des diodes PIN, devient de moins en moins efficaces pour produire une connexion électrique à impédance variable et commandée. Par ailleurs, les liquides de remplissage pour les courbes EB₁(f) à EB₄(f) étant contenus exclusivement dans le canal 4, ils ne modifient pas la transmission optique de l'ensemble de blindage 10 par rapport au cas où le canal 4 est vide (courbe EB₀(f)). Le diagramme de [Fig. 6b] illustre l'efficacité d'utiliser des fluides polarisables à la place de fluides conducteurs électriquement dans le canal 4. En outre, de multiples fluides polarisables sont disponibles avec des valeurs suffisantes de permittivité diélectrique, en présentant des toxicités et des risques pour l'environnement qui sont très inférieurs à ceux de la plupart des liquides conducteurs électriquement.

Il est entendu que l'invention peut être reproduite en modifiant des aspects secondaires des modes de réalisation qui ont été décrits en détail ci-dessus, tout en conservant certains au moins des avantages cités. Notamment, toutes les valeurs numériques qui ont été citées ne l'ont été qu'à titre d'illustration, et peuvent être changées en fonction de l'application considérée. En particulier, un ensemble de blindage qui utilise l'invention peut avoir des dimensions quelconques pour la fenêtre de transmission qu'il constitue pour le rayonnement optique, pour le rayonnement hyperfréquence ou pour les deux, notamment un diamètre de fenêtre de transmission qui peut être supérieur ou inférieur à 50 mm.

## Revendications

1. Ensemble de blindage électromagnétique transparent optiquement (10), comprenant :
- un substrat (1) rigide ayant deux faces (S₁, S₂) opposées, au moins partiellement transparent entre lesdites deux faces pour au moins un rayonnement électromagnétique qui possède une fréquence comprise entre 0,1 GHz et 40 GHz, dit rayonnement hyperfréquence (HYF), et aussi au moins partiellement transparent entre lesdites deux faces pour un rayonnement optique (RO) qui possède une longueur d'onde comprise entre 0,1 µm et 15 µm, ledit substrat étant en outre isolant électriquement ; et
- une zone de contact électrique (3), qui est située à proximité d'une périphérie du substrat (1), et qui est destinée à être connectée électriquement à une borne de source électrique ou à une borne de masse électrique,
**caractérisé en ce qu'**il comprend en outre :
- au moins un canal (4), qui est agencé pour maintenir un fluide conducteur électriquement ou polarisable en contact avec la zone de contact électrique (3) lorsque ledit au moins un canal est rempli avec le fluide ;
de sorte qu'une efficacité de blindage de l'ensemble de blindage (10), effective pour le rayonnement hyperfréquence (HYF) qui traverse le substrat (1) entre les deux faces (S₁, S₂), soit augmentée lorsque le fluide conducteur ou polarisable contenu dans l'au moins un canal (4) réduit une impédance électrique qui existe entre la zone de contact électrique (3) et un point (M) du substrat qui est distant de la périphérie dudit substrat, par rapport à un état de l'ensemble de blindage où aucun chemin électrique qui soit constitué au moins partiellement par du fluide conducteur ou polarisable ne relie ledit point du substrat à ladite zone de contact électrique.

2. Ensemble de blindage (10) selon la revendication 1, dans lequel l'au moins un canal (4) relie la zone de contact électrique (3) au point (M) du substrat (1) qui est distant de la périphérie dudit substrat.

3. Ensemble de blindage (10) selon la revendication 2, dans lequel l'au moins un canal (4) comprend un réseau bidimensionnel de canaux qui s'étend sur l'une des faces (S₁, S₂) du substrat (1).

4. Ensemble de blindage (10) selon la revendication 1, comprenant en outre :
- une structure bidimensionnelle fixe et conductrice électriquement (2), qui est disposée sur au moins une des faces (S₁, S₂) du substrat (1), qui recouvre le point (M) du substrat situé à l'intérieur de la périphérie, qui est séparée électriquement de la zone de contact électrique (3), et qui est au moins partiellement transparente pour le rayonnement optique (RO),
l'au moins un canal (4) étant agencé pour que le fluide, lorsque ledit fluide remplit ledit au moins un canal, réduise une impédance électrique qui existe entre la zone de contact électrique (3) et la structure bidimensionnelle fixe et conductrice (2).

5. Ensemble de blindage (10) selon la revendication 4, dans lequel la structure bidimensionnelle fixe et conductrice (2) comprend une grille d'un matériau solide conducteur électriquement, ou une couche d'un matériau solide conducteur électriquement et transparent pour le rayonnement optique (RO), ladite grille ou couche étant disposée sur l'au moins une des faces (S₁, S₂) du substrat (1).

6. Ensemble de blindage (10) selon l'une quelconque des revendications 1 à 5, comprenant en outre :
- des moyens d'injection du fluide dans l'au moins un canal (4) ;
- un détecteur (30) d'une intensité du rayonnement hyperfréquence (HYF), qui est situé à proximité d'une des faces (S₁, S₂) du substrat (1) ; et
- des moyens de commande (31), qui sont agencés pour déclencher un fonctionnement des moyens d'injection du fluide lorsque l'intensité du rayonnement hyperfréquence (HYF), mesurée par le détecteur (30), devient supérieure à un seuil.

7. Ensemble de blindage (10) selon la revendication 6, comprenant en outre une quantité du fluide conducteur ou polarisable, ledit fluide conducteur ou polarisable étant sélectionné parmi un métal liquide, un alliage de plusieurs métaux qui est liquide à une température d'utilisation de l'ensemble de blindage, un solvant qui contient des ions dissouts ou des particules conductrices ou polarisables en suspension, de l'eau pure, une solution acide, une solution basique, un alcool, une cétone, ou un mélange d'au moins deux parmi l'eau, une solution acide, une solution basique, un alcool et une cétone.

8. Ensemble de blindage (10) selon l'une quelconque des revendications 1 à 5, comprenant en outre une quantité du fluide conducteur ou polarisable, le fluide conducteur ou polarisable étant sélectionné pour présenter une transition entre deux états dudit fluide, lesdits états étant associés à des valeurs respectives de conductivité électrique du fluide qui sont différentes, et/ou à des valeurs respectives de permittivité diélectrique du fluide qui sont différentes,
l'ensemble de blindage (10) comprenant en outre :
- des moyens de modification du fluide, qui sont adaptés pour faire passer le fluide d'un des deux états à l'autre ;
- un détecteur (30) d'une intensité du rayonnement hyperfréquence (HYF), qui est situé à proximité d'une des faces (S₁, S₂) du substrat (1) ; et
- des moyens de commande (31), qui sont agencés pour déclencher un fonctionnement des moyens de modification du fluide lorsque l'intensité du rayonnement hyperfréquence (HYF), mesurée par le détecteur (30), devient supérieure à un seuil.

9. Système de détection (100) comprenant :
- un capteur optique (20), qui est sensible au rayonnement optique (RO) ;
- au moins une partie d'une coque (101) conductrice électriquement, qui entoure le capteur optique (20) et qui comporte une ouverture ; et
- un ensemble de blindage (10) qui est conforme à l'une quelconque des revendications précédentes, avec le substrat (1) dudit ensemble de blindage qui est disposé devant une entrée optique (E₂₀) du capteur optique (20) en fermant l'ouverture de la partie de coque (101),
dans lequel la zone de contact électrique (3) de l'ensemble de blindage (10) est connectée électriquement à la partie de coque (101).

10. Véhicule porteur (110), qui comprend un système de détection (100) conforme à la revendication 9.

## Patentansprüche

1. Optisch transparente, elektromagnetische Abschirmanordnung (10), umfassend:
- ein starres Substrat (1) mit zwei gegenüberliegenden Flächen (S₁, S₂), das zwischen den beiden Flächen zumindest teilweise transparent ist für zumindest eine elektromagnetische Strahlung mit einer Frequenz zwischen 0,1 GHz und 40 GHz, Mikrowellenstrahlung (HYF) genannt, und zwischen den beiden Flächen auch zumindest teilweise transparent ist für eine optische Strahlung (RO) mit einer Wellenlänge zwischen 0,1 µm und 15 µm, wobei das Substrat ferner elektrisch isolierend ist; und
- einen elektrischen Kontaktbereich (3), der sich in der Nähe eines Umfangs des Substrats (1) befindet und dazu bestimmt ist, elektrisch mit einem Stromquellenanschluss oder einem elektrischen Masseanschluss verbunden zu werden,
**dadurch gekennzeichnet, dass** sie ferner umfasst:
- zumindest einen Kanal (4), der dazu ausgebildet ist, ein elektrisch leitfähiges oder polarisierbares Fluid in Kontakt mit dem elektrischen Kontaktbereich (3) zu halten, wenn der zumindest eine Kanal mit dem Fluid gefüllt ist;
so dass dann, wenn das in dem zumindest einen Kanal (4) enthaltene leitfähige oder polarisierbare Fluid eine elektrische Impedanz verringert, die zwischen dem elektrischen Kontaktbereich (3) und einer vom Umfang des Substrats beabstandeten Substratstelle (M) besteht, eine Abschirmwirkung der Abschirmanordnung (10), die bei der das Substrat (1) zwischen den beiden Flächen (S₁, S₂) durchdringenden Mikrowellenstrahlung (HYF) wirksam ist, in Bezug auf einen Zustand der Abschirmanordnung erhöht wird, in dem kein zumindest teilweise aus dem leitfähigen oder polarisierbaren Fluid bestehender elektrischer Pfad die Substratstelle mit dem elektrischen Kontaktbereich verbindet.

2. Abschirmanordnung (10) nach Anspruch 1, wobei der zumindest eine Kanal (4) den elektrischen Kontaktbereich (3) mit der vom Umfang des Substrats beabstandeten Stelle (M) des Substrats (1) verbindet.

3. Abschirmanordnung (10) nach Anspruch 2, wobei der zumindest eine Kanal (4) ein zweidimensionales Netz von Kanälen umfasst, das sich über eine der Flächen (S₁, S₂) des Substrats (1) erstreckt.

4. Abschirmanordnung (10) nach Anspruch 1, ferner umfassend:
- eine feste, elektrisch leitfähige, zweidimensionale Struktur (2), die auf zumindest einer der Flächen (S₁, S₂) des Substrats (1) angeordnet ist, die innerhalb des Umfangs liegende Stelle (M) des Substrats bedeckt, von dem elektrischen Kontaktbereich (3) elektrisch getrennt ist und zumindest teilweise transparent für die optische Strahlung (RO) ist,
wobei der zumindest eine Kanal (4) so ausgebildet ist, dass das Fluid, wenn das Fluid den zumindest einen Kanal füllt, eine elektrische Impedanz verringert, die zwischen dem elektrischen Kontaktbereich (3) und der festen, leitfähigen zweidimensionalen Struktur (2) besteht.

5. Abschirmanordnung (10) nach Anspruch 4, wobei die feste, leitfähige zweidimensionale Struktur (2) ein Gitter aus einem elektrisch leitfähigen Feststoffmaterial oder eine Schicht aus einem elektrisch leitfähigen und für die optische Strahlung (RO) transparenten Feststoffmaterial umfasst, wobei das Gitter oder die Schicht auf zumindest einer der Flächen (S₁, S₂) des Substrats (1) angeordnet ist.

6. Abschirmanordnung (10) nach einem der Ansprüche 1 bis 5, ferner umfassend:
- Mittel zum Einspritzen des Fluids in den zumindest einen Kanal (4);
- einen Detektor (30) für eine Intensität der Mikrowellenstrahlung (HYF), der sich in der Nähe einer der Flächen (S₁, S₂) des Substrats (1) befindet; und
- Steuermittel (31), die dazu ausgebildet sind, einen Betrieb der Mittel zum Einspritzen des Fluids dann auszulösen, wenn die von dem Detektor (30) gemessene Intensität der Mikrowellenstrahlung (HYF) einen Schwellenwert übersteigt.

7. Abschirmanordnung (10) nach Anspruch 6,
ferner umfassend eine Menge an leitfähigem oder polarisierbarem Fluid, wobei das leitfähige oder polarisierbare Fluid ausgewählt ist aus einem flüssigen Metall, einer Legierung mehrerer Metalle, die bei einer Betriebstemperatur der Abschirmanordnung flüssig ist, einem Lösungsmittel, das gelöste Ionen oder leitfähige oder polarisierbare Teilchen in Suspension enthält, reinem Wasser, einer sauren Lösung, einer basischen Lösung, Alkohol, einem Keton oder einer Mischung aus zumindest zwei von Wasser, saurer Lösung, basischer Lösung, Alkohol und Keton.

8. Abschirmanordnung (10) nach einem der Ansprüche 1 bis 5, ferner umfassend eine Menge an leitfähigem oder polarisierbarem Fluid, wobei das leitfähige oder polarisierbare Fluid so ausgewählt ist, dass es einen Übergang zwischen zwei Fluidzuständen aufweist, wobei die Zustände jeweils unterschiedlichen Werten der elektrischen Leitfähigkeit des Fluids und/oder jeweils unterschiedlichen Werten der dielektrischen Leitfähigkeit des Fluids zugeordnet sind,
wobei die Abschirmanordnung (10) ferner umfasst:
- Mittel zum Modifizieren des Fluids, die dazu geeignet sind, das Fluid von einem der beiden Zustände in den anderen zu überführen;
- einen Detektor (30) für eine Intensität der Mikrowellenstrahlung (HYF), der sich in der Nähe einer der Flächen (S₁, S₂) des Substrats (1) befindet; und
- Steuermittel (31), die dazu ausgebildet sind, einen Betrieb der Mittel zum Modifizieren des Fluids dann auslösen, wenn die von dem Detektor (30) gemessene Intensität der Mikrowellenstrahlung (HYF) einen Schwellenwert übersteigt.

9. Sensorsystem (100), enthaltend:
- einen optischen Sensor (20), der für optische Strahlung (RO) empfindlich ist;
- zumindest ein elektrisch leitfähiges Hüllteil (101), das den optischen Sensor (20) umgibt und eine Öffnung aufweist; und
- eine Abschirmanordnung (10) nach einem der vorhergehenden Ansprüche, wobei das Substrat (1) der Abschirmanordnung vor einem optischen Eingang (E₂₀) des optischen Sensors (20) angeordnet ist und dabei die Öffnung des Hüllteils (101) verschließt,
wobei der elektrische Kontaktbereich (3) der Abschirmanordnung (10) elektrisch mit dem Hüllteil (101) verbunden ist.

10. Trägerfahrzeug (110) mit einem Sensorsystem (100) nach Anspruch 9.

## Claims

1. An optically transparent electromagnetic shielding assembly (10), comprising:
- a rigid substrate (1) having two opposite faces (S₁, S₂), which is at least partially transparent between said two faces to at least one electromagnetic radiation of a frequency between 0.1 GHz and 40 GHz, referred to as microwave radiation (HYF), and also at least partially transparent between said two faces to an optical radiation (RO) which has a wavelength between 0.1 µm and 15 µm, said substrate further being electrically insulating;
and
- an electrical contact area (3), which is located close to a periphery of the substrate (1), and which is intended to be electrically connected to a terminal of an electrical source or a terminal of an electrical ground,
**characterized in that** it further comprises:
- at least one channel (4), which is arranged to keep an electrically conducting or polarizable fluid in contact with the electrical contact area (3) when said at least one channel is filled with the fluid;
so that a shielding efficiency of the shielding assembly (10), effective for the microwave radiation (HYF) which passes through the substrate (1) between its two faces (S₁, S₂), is increased when the conducting or polarizable fluid contained in the at least one channel (4) reduces an electrical impedance that exists between the electrical contact area (3) and a point (M) of the substrate which is at a distance from the periphery of said substrate, in comparison to a state of the shielding assembly where no electrical path composed at least partially by some conducting or polarizable fluid connects said point of the substrate to said electrical contact area.

2. The shielding assembly (10) according to claim 1, wherein the at least one channel (4) connects the electrical contact area (3) to the point (M) of the substrate (1) which is at a distance from the periphery of said substrate.

3. The shielding assembly (10) according to claim 2, wherein the at least one channel (4) comprises a two-dimensional network of channels which extends over one of the faces (S₁, S₂) of the substrate (1).

4. The shielding assembly (10) according to claim 1, further comprising:
- a fixed and electrically conducting two-dimensional structure (2), which is arranged on at least one of the faces (S₁, S₂) of the substrate (1), which covers the point (M) of the substrate located inside the periphery, which is electrically separated from the electrical contact area (3), and which is at least partially transparent to the optical radiation (RO), the at least one channel (4) being arranged so that the fluid, when said fluid fills said at least one channel, reduces an electrical impedance which exists between the electrical contact area (3) and the fixed and conducting two-dimensional structure (2).

5. The shielding assembly (10) according to claim 4, wherein the fixed and conducting two-dimensional structure (2) comprises a grid of a solid electrically conducting material, or a layer of a solid electrically conducting material that is transparent to the optical radiation (RO), said grid or layer being placed on the at least one of the faces (S₁, S₂) of the substrate (1).

6. The shielding assembly (10) according to any one of claims 1 to 5, further comprising:
- fluid injection means for injecting fluid into the at least one channel (4);
- a detector (30) for detecting an intensity of the microwave radiation (HYF), which is located close to one of the faces (S₁, S₂) of the substrate (1); and
- control means (31), which are arranged to trigger operation of the fluid injection means when the intensity of the microwave radiation (HYF), measured by the detector (30), becomes greater than a threshold.

7. The shielding assembly (10) according to claim 6, further comprising a quantity of the conducting or polarizable fluid, said conducting or polarizable fluid being selected among a liquid metal, an alloy of several metals which is liquid at a temperature of use of the shielding assembly, a solvent which contains dissolved ions or conducting or polarizable particles in suspension, pure water, an acidic solution, a basic solution, an alcohol, a ketone, or a mixture of at least two among water, an acidic solution, a basic solution, an alcohol, and a ketone.

8. The shielding assembly (10) according to any one of claims 1 to 5, further comprising a quantity of the conducting or polarizable fluid, the conducting or polarizable fluid being selected so as to exhibit a transition between two states of said fluid, said states being associated with different respective electrical conductivity values of the fluid, and/or with different respective dielectric permittivity values of the fluid, the shielding assembly (10) further comprising:
- fluid modification means, which are suitable for changing the fluid from one of the two states to the other;
- a detector (30) for detecting an intensity of the microwave radiation (HYF), which is located close to one of the faces (S₁, S₂) of the substrate (1); and
- control means (31), which are arranged to trigger operation of the fluid modification means when the intensity of the microwave radiation (HYF), measured by the detector (30), becomes greater than a threshold.

9. A detection system (100) comprising:
- an optical sensor (20), which is sensitive to the optical radiation (RO);
- at least a portion of an electrically conducting shell (101), which surrounds the optical sensor (20) and which comprises an opening; and
- the shielding assembly (10) in accordance with any one of the preceding claims, the substrate (1) of said shielding assembly being arranged in front of an optical input (E₂₀) of the optical sensor (20) while closing off the opening in the shell portion (101),
wherein the electrical contact area (3) of the shielding assembly (10) is electrically connected to the shell portion (101).

10. A carrier vehicle (110), which comprises the detection system (100) that is according to claim 9.
